# EUROPÄISCHE PATENTSCHRIFT

(11) **EP 2 976 176 B1**
(45) Veröffentlichungstag und Bekanntmachung des Hinweises auf die Patenterteilung: **03.10.2018**
(21) Anmeldenummer: 14710539.9
(22) Anmeldetag: 13.03.2014
(51) Int. Cl.: B23K 26/00, B23K 26/06, G03F 7/20

(54) **VERFAHREN UND ANORDNUNG ZUR AUSBILDUNG EINER STRUKTURIERUNG AN OBERFLÄCHEN VON BAUTEILEN MIT EINEM LASERSTRAHL**
METHOD AND DEVICE FOR FORMING A STRUCTURED SURFACE BY MEANS OF A LASER BEAM
MÉTHODE ET DISPOSITIF POUR FORMER UNE SURFACE STRUCTURÉE AU MOYEN D'UN FAISCEAU LASER

(30) Priorität: 21.03.2013 DE 102013004869
(43) Veröffentlichungstag der Anmeldung: 27.01.2016
(73) Patentinhaber: Fraunhofer-Gesellschaft zur Förderung der angewandten Forschung e.V., 80686 München (DE)
(72) Erfinder: ROCH, Teja, 01309 Dresden (DE); BENKE, Dimitri, 69469 Weinheim (DE); LASAGNI, Andrés, Fabián, 01723 Grumbach (DE)
(74) Vertreter: Pfenning, Meinig & Partner mbB
(86) Internationale Anmeldenummer: PCT/EP2014/055018
(87) Internationale Veröffentlichungsnummer: WO 2014/146974

(56) Entgegenhaltungen:
- EP-A1- 2 292 370
- US-A1- 2010 060 876

## Beschreibung

Die Erfindung betrifft ein Verfahren und eine Anordnung zur Ausbildung einer Strukturierung an Oberflächen von Bauteilen mit einem Laserstrahl. Mit der Erfindung können ein- oder zweidimensionale Strukturelemente (Pixel) ausgebildet werden. Die Ausbildung der Strukturelemente erfolgt dabei mittels Laserinterferenzstrukturierung.

Bisher wurde dabei ein Laserstrahl auf ein optisches diffraktives Element gerichtet, mit dem der Laserstrahl in mehrere Teilstrahlen aufgeteilt werden kann. Die Teilstrahlen werden dann mit zwei in einem Abstand zueinander angeordneten optischen fokussierenden Linsen auf eine zu strukturierende Oberfläche gerichtet. Dabei werden die Teilstrahlen mit einer der beiden Linsen zusätzlich in ihrer Strahlrichtung so verändert, dass sie auf den gleichen Oberflächenbereich eines Bauteils auftreffen. Da die optischen Linsen eine konstante Brennweite aufweisen, ist ein Austausch gegen mindestens eine andere, eine davon unterschiedliche Brennweite aufweisende Linse erforderlich, wenn die Interferenzperiode verändert werden soll.

Bei einer anderen bekannten Möglichkeit zur Laserinterferenzstrukturierung wird ein Laserstrahl mittels mindestens eines Strahlteilers in Teilstrahlen aufgeteilt und die Teilstrahlen werden mit Hilfe von reflektierenden Elementen aus unterschiedlichen Richtungen auf die zu strukturierende Oberfläche gerichtet. Dabei sollen die Teilstrahlen jeweils die gleiche Weglänge bis zum Auftreffen auf die Oberfläche durchlaufen. Ein solcher Aufbau benötigt ein großes Volumen, so dass kein kompakter Aufbau möglich ist. Für eine Anpassung der Interferenzperiode ist eine aufwändige präzise Justierung von reflektierenden optischen Elementen erforderlich.

Aus der DE 102 59 443 A1 sind ein Verfahren und eine Anordnung zur optischen Untersuchung und/oder einer Bearbeitung einer Probe bekannt.

Die DE 10 2006 000 720 A1 betrifft eine Laserbearbeitungsmaschine zur Ausbildung von Nuten.

Eine diffraktiv-optische Anordnung ist in DE 10 2006 061 066 A1 beschrieben.

Möglichkeiten zur Laserinterferenzstrukturierung sind aus DE 10 2011011 734 A1 bekannt.

Eine Strukturierung, ein Verfahren zur Herstellung der Strukturierung und ein Verfahren zur Trennung richtiger und falscher Objekte sind aus EP 2 292 370 A1 bekannt.

US 2010/0060876 A1 betrifft eine Vorrichtung zur Lichterzeugung und ein Verfahren zur Steuerung der Vorrichtung.

Es ist daher Aufgabe der Erfindung, einen einfachen kompakten Aufbau, der zu einer Laserinterferenzstrukturierung ausgebildet ist, zur Verfügung zu stellen, der in einen mobilen Aufbau integrierbar ist und mit dem insbesondere die Interferenzperiode bei der Ausbildung von Strukturelementen veränderbar ist.

Erfindungsgemäß wird diese Aufgabe mit einem Verfahren, das die Merkmale des Anspruchs 1 aufweist, gelöst. Der Anspruch 10 definiert eine Anordnung. Vorteilhafte Ausgestaltungen und Weiterbildungen der Erfindung sind mit in untergeordneten Ansprüchen bezeichneten Merkmalen realisierbar.

Bei dem erfindungsgemäßen Verfahren zur Ausbildung einer Oberflächenstrukturierung an Oberflächen von Bauteilen mit einem Laserstrahl wird der der Laserstrahl auf ein diffraktives optisches Element oder einen akusto-optischen Modulator gerichtet. Das diffraktive optische Element oder der akusto-optischen Modulator ist so ausgebildet, dass der Laserstrahl in mindestens zwei Teilstrahlen aufgespalten und die Teilstrahlen mit einem Winkel α in Bezug zur optischen Achse des Laserstrahls auf mindestens ein weiteres optisches Element, das für die Laserstrahlung transparent ist, gerichtet werden, wobei der Winkel α bevorzugt jeweils gleich groß ist.

Ein akusto-optischer Modulator weist ein ähnliches Funktionsprinzip, wie ein diffraktiv optisches Element auf. Es wird ein optisches Gitter durch den Einfluss von Schallwellen bewegt.

Nachfolgend soll lediglich der Begriff diffraktives optisches Element genutzt werden, obwohl anstelle dessen auch ein akusto-optischer Modulator oder ähnlich Phasengitter eingesetzt werden kann.

Das eine bzw. mehrere weitere optische Element(e) weist/weisen eine erste Oberfläche auf, die bevorzugt senkrecht in Bezug zur optischen Achse des Laserstrahls ausgerichtet ist. Eine zweite Oberfläche, die der ersten Oberfläche gegenüberliegend ausgebildet ist, ist in einem Winkel zur optischen Achse des Laserstrahls geneigt. Dadurch kann die Strahlrichtung der Teilstrahlen durch optische Brechung verändert werden. Die Teilstrahlen können dann vorteilhaft parallel zur optischen Achse des Laserstrahls ausgerichtet sein. Im Strahlengang der Teilstrahlen ist zwischen dem/den weiteren optischen Element(en) und einer zu bearbeitenden Bauteiloberfläche eine fokussierende optische Linse angeordnet. Damit werden die Teilstrahlen so fokussiert, dass sie an einer gemeinsamen Position mit einem Einfallswinkel β, der bevorzugt gleich groß ist, in Bezug zur optischen Achse des Laserstrahls auf die Oberfläche des Bauteils auftreffen. Sie können dabei aus unterschiedlichen Richtungen gespiegelt in Bezug zur optischen Achse des Laserstrahls auf die zu strukturierende Oberfläche auftreffen.

Der Laserstrahl sollte von einer gepulst betriebenen Laserstrahlquelle emittiert werden. Dabei können Pulsdauern im Bereich von Nanosekunden bis hin in den noch kleineren Pikosekundenbereich gewählt werden. Dies kann insbesondere dadurch erreicht werden, dass eine sehr kleine Weglängendifferenz der Teilstrahlen bis zum Auftreffen auf die zu strukturierende Oberfläche eingehalten werden kann. Außerdem kann ein Lasersystem eingesetzt werden, das eine geringe Kohärenzlänge aufweist.

Ein weiteres optisches Element kann als ein optisches Prisma, eine Keilplatte, an einer Oberfläche in Form einer Pyramide oder eines Pyramidenstumpfes, in Form eines Polyeders, in Form eines Kegels oder eines Kegelstumpfes ausgebildet sein. Dabei ist es möglich, die Teilstrahlen zuerst senkrecht auf die senkrecht zur optischen Achse des Laserstrahls ausgerichtete Oberfläche des weiteren optischen Elements auftreffen zu lassen und die Umlenkung der Teilstrahlen durch optische Brechung an der in Strahlausbreitungsrichtung danach angeordneten entsprechend in einem Winkel geneigten Oberfläche des weiteren optischen Elements zu erreichen. Das weitere optische Element kann aber auch um 180 ° gedreht im Strahlengang der Teilstrahlen angeordnet sein.

Bei einer Ausbildung der erfindungsgemäßen Anordnung bei der lediglich eine Aufspaltung des Laserstrahls in zwei Teilstrahlen erfolgt, kann das weitere optische Element bevorzugt als optisches Prisma oder mit zwei Keilplatten, deren Keile entgegengesetzt zueinander ausgerichtet sind, gebildet sein. Zwei Keilplatten sollten mit einer Fläche, die parallel zur optischen Achse des Laserstrahls ausgerichtet ist direkt aneinander liegen oder diese Flächen einen jeweils gleich großen Abstand zur optischen Achse aufweisen, so dass die Teilstrahlen mit gleichem Abstand zur optischen Achse des Laserstrahls auf eine Oberfläche der Keilplatten auftreffen und auch an einer Position mit jeweils gleichem Abstand zur optischen Achse des Laserstrahls beim Austreten gebrochen und in ihrer Strahlrichtung verändert werden. Dabei sollten die Keilplatten und die Winkel α gleich groß sein sowie die Teilstrahlen die gleiche Weglänge bis zum Auftreffen auf die zu strukturierende Oberfläche zurück legen.

Bei mehr als zwei Teilstrahlen können ein Polyeder, ein Kegel oder ein Kegelstumpf bei einem weiteren optischen Element genutzt werden. Es können aber auch mehr als zwei Keilplatten entsprechend der Anzahl der Teilstrahlen eingesetzt werden, wobei jeweils ein Teilstrahl auf eine Keilplatte gerichtet werden kann. Bei vier Teilstrahlen bietet sich eine Pyramiden- oder Pyramidenstumpfform an.

Die bei der Erfindung einsetzbare Anordnung kann so ausgebildet sein, dass die fokussierende optische Linse gegen eine fokussierende optische Linse mit anderer Brennweite ausgetauscht werden kann.

Als diffraktives optisches Element kann bevorzugt ein optisches Gitter eingesetzt werden. Dabei sollte es so ausgebildet sein, dass die jeweilig gewünschte Anzahl an Teilstrahlen erhalten werden kann und die Teilstrahlen den jeweils gleichen Winkel α im weiteren Verlauf des Strahlengangs nach dem diffraktiven optischen Element einhalten.

Durch Veränderung des Abstandes d1 zwischen dem diffraktiven optischen Element und dem weiteren optischen Element wird der jeweilige Abstand Δx der Teilstrahlen von der optischen Achse des Laserstrahls im Bereich des Strahlengangs zwischen dem/den weiteren optischen Element(en) und der fokussierenden Linse und auch der Einfallswinkel β der Teilstrahlen und die Interferenzperiode sehr einfach verändert, wenn Veränderungen bei der auszubildenden Strukturierung gewünscht werden.

In einer weiteren vorteilhaften Ausführung kann der Laserstrahl mindestens eindimensional ausgelenkt auf das diffraktive optische Element gerichtet werden, so dass der Auftreffort auf die Oberfläche des diffraktiven optischen Elements und somit eine Verschiebung der optischen Achsen der Teilstrahlen und eine eindimensionale Verschiebung der Position auf die die Teilstrahlen gemeinsam auf die Oberfläche des Bauteils gerichtet werden, erreicht wird. Für die Auslenkung des Laserstrahls oder von Teilstrahlen kann mindestens ein um mindestens eine Achse verschwenkbares reflektierendes Element im Strahlengang des Laserstrahls oder der Teilstrahlen angeordnet sein. Es ist auch eine zweidimensionale Auslenkung des Laserstrahls möglich, wofür ein entsprechend um zwei senkrecht zueinander ausgerichtete Achsen verschwenkbares oder zwei um jeweils eine Achse verschwenkbare reflektierende optische Elemente dort angeordnet werden können.

Durch die so erreichbare laterale Bewegung der Position auf die die beiden Teilstrahlen gemeinsam auf die Oberfläche des Bauteils auftreffen kann der Laser mit einer Pulsfrequenz von z.B. > 2 kHz eingesetzt werden, die ohne eine solche Spiegelanordnung nicht möglich ist.

Vorteilhaft ist es auch möglich, das diffraktive optische Element um eine Achse zu drehen, wodurch eine Drehung von Interferenzlinien möglich ist und entsprechende Strukturierungen ausgebildet werden können. Das diffraktive optische Element kann dabei um eine parallel zur optischen Achse des senkrecht auf das diffraktive optische Element gerichteten Laserstrahls gedreht werden.

Es besteht auch die Möglichkeit den Abstand d2 zwischen dem weiteren optischen Element und der fokussierenden optischen Linse zu verändern. Dadurch kann die Ausrichtung der Teilstrahlen verändert und eine entsprechende Veränderung der Größe der Strukturierung erreicht werden, da die Winkel, mit denen die Teilstrahlen auf das fokussierende optische Element und die Oberfläche des Bauteils gerichtet werden, dadurch verändert werden können. Alternative zu einer optischen Linse können Objektive z.B. in Form eines f-Theta Objektives eingesetzt werden.

In einer Ausführungsform der Erfindung kann auch ein Laserstrahl eingesetzt werden, der einen nichtrotationssymmetrischen Querschnitt und/oder ein modifiziertes, beispielsweise ein nichtrotationssymmetrisches oder ein über die Querschnittsfläche inhomogenes Intensitätsprofil des Laserstrahls aufweist. Ein so ausgebildeter Laserstrahl kann auf die Oberfläche eines diffraktiven optischen Elements gerichtet und in mehrere Teilstrahlen geteilt werden, die dann wieder auf der Oberfläche eines Bauteils interferieren können.
Ein nichtrotationssymmetrischer Querschnitt des Laserstrahls, der auf das diffraktive optische Element gerichtet wird, kann mittels der bereits erwähnten Auslenkung mit mindestens einem reflektiven Element erreicht werden, wenn der Laserstrahl nicht senkrecht auf die Oberfläche des diffraktiven Elements auftrifft. Es kann dazu auch mindestens ein reflektives Element mit einer entsprechend gekrümmten Oberfläche eingesetzt werden.

Ein modifiziertes Intensitätsprofil kann mit einem semitransparenten oder semireflektierenden Element erreicht werden, das über die Fläche auf die der Laserstrahl auftrifft einen Transmissions- oder Reflexionsgradienten für die jeweilige Laserstrahlung aufweist. Dadurch kann z.B. ein so genanntes Gauss→top hat- oder ein top hat →Gauss-Profil ausgebildet werden. Es kann dadurch eine punktuell erhöhte Energiedichte mit einer erhöhten Zerstörungsschwelle und entsprechend erhöhtem Werkstoffabtrag auf kleinerer Fläche auf der Oberfläche des Bauteils erreicht werden. Es kann dabei aber ein geringer Leistungsverlust in Bereichen mit reduzierter Intensität/Energiedichte der auftreffenden Teilstrahlen in Kauf genommen werden. Für die Ausbildung eines nichtrotationssymmetrischen oder eines über die Querschnittsfläche des Laserstrahls inhomogenes Intensitätsprofils kann auch ein adaptives optisches Element oder eine entsprechende optische Anordnung mehrerer optischer Elemente eingesetzt werden, auf und/oder durch die der Laserstrahl gerichtet wird. Als adaptive optische Elemente können beispielsweise reflektierende Elemente eingesetzt werden, die eine bevorzugt unregelmäßig gekrümmte Oberfläche aufweisen oder deren Oberfläche, auf die der Laserstrahl gerichtet wird, in ihrer Wölbung verändert werden kann.

Die bei der Erfindung einsetzbare Anordnung kann sehr kompakt, also mit einem kleinen erforderlichen Volumen und entsprechend kleiner Eigenmasse ausgebildet sein. Sie kann daher in Verbindung mit einem Manipulator genutzt werden, so dass eine auch mehrdimensionale Bewegung bei der Oberflächenstrukturierung von Bauteilen, die auch großformatig sein und eine große Masse aufweisen können, auf größeren Oberflächenbereichen erreicht werden kann.

Es besteht auch die Möglichkeit, linienförmige Strukturelemente mit unterschiedlicher Ausrichtung auf einer Bauteiloberfläche auszubilden, die dann darauf ein Muster oder eine konkrete Abbildung ausbilden können.

Dabei kann auch erreicht werden, dass bei der Betrachtung der strukturierten Oberfläche aus geeigneten Betrachtungswinkeln ein farbiger Eindruck hervor gerufen werden kann.

Die Teilstrahlen können auch bei hoher Fokussierung einfach auf der zu strukturierenden Oberfläche überlappt werden. Dabei ist es lediglich erforderlich den der Brennweite der fokussierenden optischen Linse berücksichtigenden Abstand zwischen dieser Linse und der zu strukturierenden Oberfläche einzuhalten.

Mit mehr als zwei Teilstrahlen in der der Laserstrahl aufgeteilt wird, können punktförmige Strukturen ausgebildet werden.

Die bei der Erfindung einsetzbare Anordnung kann auch so ausgebildet sein, dass sie um eine Achse, bevorzugt die optische Achse des Laserstrahls gedreht werden kann.

Nachfolgend soll die Erfindung beispielhaft näher erläutert werden. Dabei können die in den unterschiedlichen Beispielen gezeigten und erläuterten Merkmale unabhängig vom jeweiligen Beispiel miteinander kombiniert werden.

Dabei zeigen:
- Figur 1: in schematischer Form ein Beispiel einer bei der Erfindung einsetzbaren Anordnung;
- Figur 2: ein Diagramm mit dem die Abhängigkeit der Interferenzperiode vom Abstand d1 verdeutlicht ist;
- Figur 3: eine schematische Darstellung von mit der Erfindung ausbildbaren Strukturen auf der Oberfläche eines Bauteils; und
- Figur 4: eine schematische Darstellung von zwei Beispielen einer bei der Erfindung einsetzbaren Anordnung ;

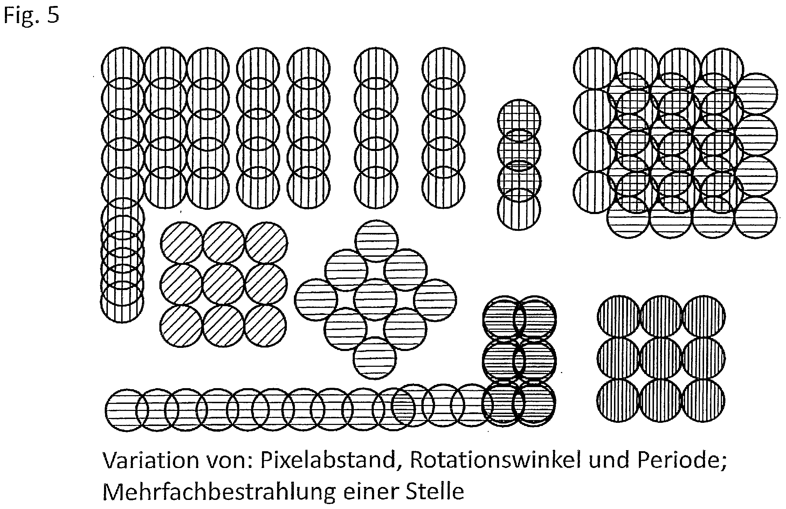

- Figur 5: weitere Beispiele von mit der Erfindung ausbildbaren Oberflächenstrukturen mit veränderten Abständen von Strukturelementen, veränderten Ausrichtungen und Perioden, die nach Mehrfachbestrahlung an einer Position ausgebildet werden können;
- Figur 6: ein Beispiel, bei dem der Laserstrahl mit einem semitransparenten Spiegel geformt wird, mit zwei verschwenkbaren reflektierenden Elementen auf ein diffraktives optisches Element gerichtet wird und
- Figur 7: in schematischer Form den möglichen Einsatz eines akustooptischen Modulators für eine Teilung eines Laserstrahls in Teilstrahlen.

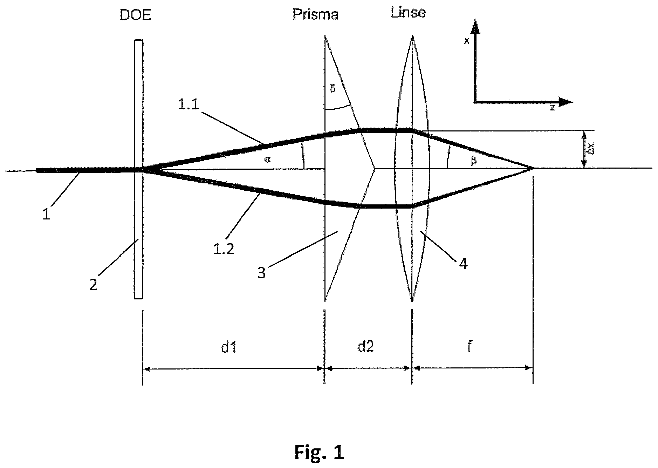

In Figur 1 ist beispielhaft eine Anordnung gezeigt, bei der ein Laserstrahl 1 auf ein diffraktives optisches Element 2 gerichtet ist, mit dem bei diesem Beispiel der eine Laserstrahl 1 in zwei Teilstrahlen 1.1 und 1.2 aufgespalten und beide Teilstrahlen 1.1 und 1.2 um jeweils einen Winkel α in Bezug zur optischen Achse des Laserstrahls 1 abgelenkt werden. Beide Teilstrahlen 1.1 und 1.2 treffen auf eine senkrecht zur optischen Achse des Laserstrahls 1 ausgerichtete Oberfläche eines optischen Prismas, als weiteres optisches Element 3 auf. Da das weitere optische Element 3 für die Laserstrahlung transparent ist, erfolgt an der gegenüberliegenden Oberfläche des weiteren optischen Elements 3, die in einem Winkel ‡ 90 ° in Bezug zur optischen Achse geneigt ist, eine weitere Ablenkung der beiden Teilstrahlen 1.1 und 1.2 in Abhängigkeit des Neigungswinkels dieser Oberfläche und des optischen Brechungsindex des weiteren optischen Elements 3. Dabei sollten die beiden Teilstrahlen 1.1 und 1.2 bevorzugt parallel zur optischen Achse und dabei in jeweils gleichem Abstand Δx zur optischen Achse des Laserstrahls 1 zwischen dem weiteren optischen Element und der fokussierenden optischen Linse verlaufen.

Beide Teilstrahlen 1.1 und 1.2 werden dann mit der fokussierenden optischen Linse 4 auf die zu strukturierende Oberfläche fokussiert und treffen an einer gemeinsamen Position mit jeweils dem gleichen Einfallswinkel β aus verschiedenen Richtungen gespiegelt zur optischen Achse des Laserstrahls 1 auf die zu strukturierende Oberfläche des Bauteils auf. Dort erfolgt ein gezielter Werkstoffabtrag oder eine Veränderung des Bauteilwerkstoffs durch eine Phasenumwandlung oder ein Aufschmelzen infolge der Interferenz der beiden Teilstrahlen 1.1 und 1.2.

An Stelle des optischen Prismas können auch zwei Keilplatten eingesetzt werden. Es kann auch ein anderes diffraktives optisches Element 2 eingesetzt werden, mit dem der Laserstrahl 1 in mehr als zwei Teilstrahlen aufgespalten werden kann. In diesem Fall sollte ein an die Lage und Ausrichtung der mehr als zwei Teilstrahlen angepasstes weiteres optisches Element 3 eingesetzt werden. Beispiele hierfür sind im allgemeinen Teil der Beschreibung genannt.

Besonders vorteilhaft kann der Abstand d1 zwischen dem diffraktiven optischen Element 2 und dem weiteren optischen Element 3 verändert werden. Dadurch kann die Interferenzperiode sehr einfach ebenfalls verändert werden, so dass entsprechend unterschiedliche Strukturelemente an der Oberfläche eines Bauteils ausgebildet werden können.

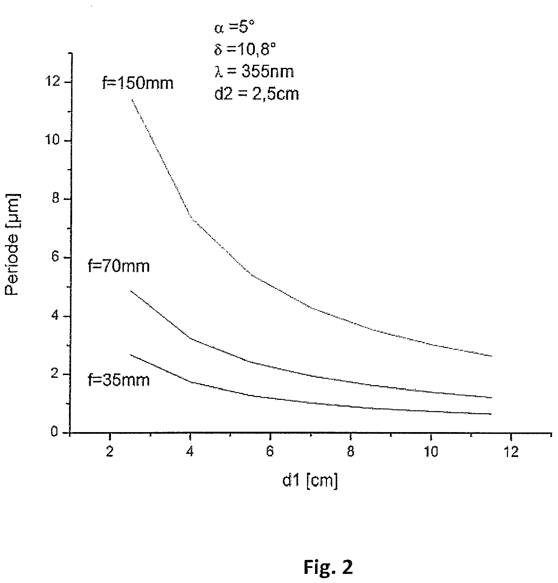

Die Abhängigkeit der Interferenzperiode vom Abstand d1 ist für drei fokussierende optische Linsen 4 mit Brennweiten von 35 mm, 70 mm und 150 mm im in Figur 2 gezeigten Diagramm verdeutlicht. Es ist dabei erkennbar, dass bereits kleine Veränderungen des Abstands d1 einen großen Einfluss auf die dadurch erreichbare Veränderung der Interferenzperiode haben und dieser Effekt bei größeren Brennweiten der fokussierenden optischen Linse noch verstärkt ist.

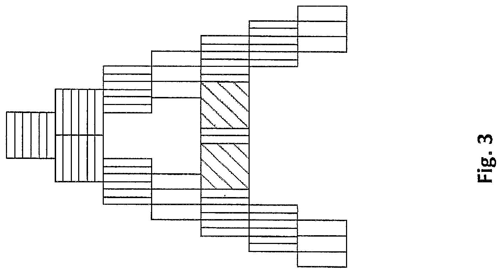

In Figur 3 ist eine auf einer Bauteiloberfläche ausgebildete Strukturierung beispielhaft angegeben. Dabei können die Teilstrahlen mit verschiedenen Interferenzperioden auf die Oberfläche fokussiert werden, wodurch linienförmige Strukturelemente mit unterschiedlich großen Abstanden zueinander an verschiedenen Positionen ausgebildet werden können. Dies ist einfach durch die Variation des Abstandes d1 erreichbar.

Da eine bei der Erfindung einsetzbare Anordnung sehr einfach und kompakt ausgebildet ist, können solche Muster auch in unterschiedlicher Ausrichtung ausgebildet werden. Die Anordnung kann dabei einfach um die optische Achse des Laserstrahls 1 mit dem jeweils gewünschten Winkel gedreht werden. Wie in Figur 3 erkennbar können linienförmige Strukturen vertikal, horizontal oder in jedem beliebigen davon abweichenden Winkel an verschiedenen Positionen auf einer Bauteiloberfläche ausgebildet und dort dadurch auch unterschiedliche Effekte erreicht werden.

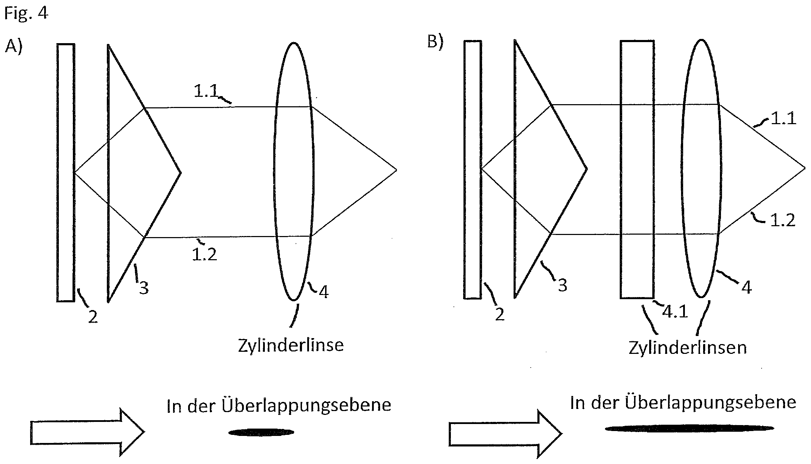

In Figur 4 sind zwei Beispiele einer bei der Erfindung einsetzbaren Anordnung schematisch dargestellt. Dabei ist ein Laserstrahl 1 auf ein diffraktives Element 2 gerichtet, mit dem er in zwei Teilstrahlen 1.1 und 1.2 aufgeteilt wird und auf eine senkrecht zur optischen Achse des Laserstrahls 1 ausgerichtete Oberfläche eines Biprismas 3, als weiteres optisches Element, gerichtet und treten an der Rückseite des Biprismas wieder aus und werden so gebrochen, dass sie bei beiden in Figur 4 gezeigten Beispielen parallel zur optischen Achse des Laserstrahls 1 ausgerichtet sind.

Die beiden Teilstrahlen 1.1 und 1.2 werden bei dem in Figur 4 links dargestellten Beispiel auf eine Zylinderlinse als fokussierendes optisches Element 4 gerichtet, damit die Teilstrahlen 1.1 und 1.2 auf eine zu bearbeitende Oberfläche fokussiert werden, so dass die Teilstrahlen 1.1 und 1.2 an der Oberfläche interferieren.

Bei dem rechts in Figur 4 gezeigten Beispiel ist zusätzlich zwischen dem Biprisma 3 und der Zylinderlinse als fokussierendes Element 4 eine weitere Zylinderlinse 4.1 angeordnet.

Für beide Beispiele ist unterhalb der Anordnung verdeutlicht worden, dass die Überlappungsebene der Teilstrahlen 1.1 und 1.2 bei dem links in Figur 4 angeordneten Beispiel kürzer, als bei dem rechts in Figur 4 gezeigten Beispiel ist.

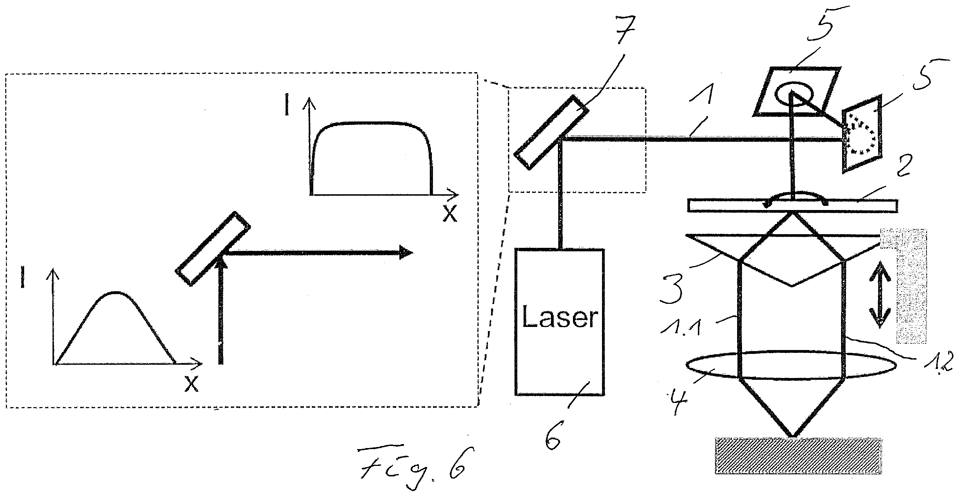

Die Figur 6 zeigt in schematischer Form ein Beispiel einer bei der Erfindung einsetzbaren Anordnung, bei der der Laserstrahl 1 auf einen semitransparenten Spiegel und zwei um jeweils eine Achse verschwenkbare reflektierende Elemente 5 gerichtet wird. Dabei sind die Drehachsen der reflektierenden Elemente 5 senkrecht zueinander ausgerichtet. Der Laserstrahl 1 kann so zweidimensional ausgerichtet werden und an verschiedenen Positionen auf die Oberfläche des diffraktiven optischen Elements 2 auftreffen. Dadurch verändern sich die Positionen an denen Teilstrahlen 1.1 und 1.2 aus dem diffraktiven optischen Element 2 austreten und demzufolge auch die Position an denen die Teilstrahlen 1.1 und 1.2 gemeinsam auf die Oberfläche des Bauteils 3 auftreffen und dort eine Strukturierung ausbilden können. Dadurch kann zusätzlich Einfluss auf die auszubildende Struktur genommen werden.

In nicht dargestellter Form kann auch der Abstand d2 zwischen dem weiteren optischen Element 3 und der fokussierenden optischen Linse 4 verändert werden. Das weitere optische Element 3 kann hierbei ein Biprisma oder auch ein kegelförmiges (Axicon) oder ein pyramidenförmiges Element sein, dessen Spitze in Richtung Bauteil 3 weist. Neben den bereits erwähnten Fokussier- und Zylinderlinsen kann für die Fokussierung auch eine F-Theta-Linse als fokussierendes optisches Element 4 eingesetzt werden. Dabei kann das weitere optische Element 3 parallel zur optischen Achse des Laserstrahls 1 translatorisch bewegt werden.

Bei diesem Beispiel ist im Strahlengang zwischen Laserquelle 6 und den reflektierenden Elementen 5 ein semitransparentes reflektierendes Element 7 vorhanden, das über die Fläche auf die der Laserstrahl 1 auftrifft, einen Transmissionsgradienten für die jeweilige Laserstrahlung aufweist. Damit ist z. B. ein nichtrotationssymmetrisches Intensitätsprofil des Laserstrahls 1, der auf das diffraktive optische Element 2 auftrifft erreichbar. Auch das Intensitätsprofil der Teilstrahlen 1.1 und 1.2 kann dadurch nichtrotationssymmetrisch sein.

Bei allen gezeigten Beispielen besteht auch die Möglichkeit das diffraktive optische Element 2 um eine Achse zu drehen. Diese kann bevorzugt parallel zur optischen Achse mit der der Laserstrahl 1 auf die Oberfläche auf das diffraktive optische Element 2 auftrifft ausgerichtet sein.

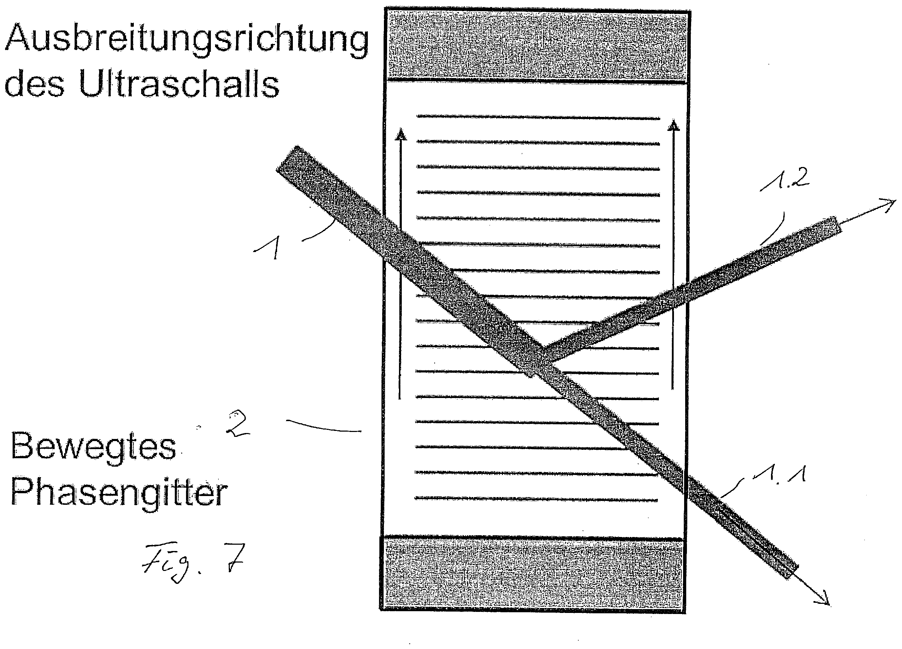

Figur 7 zeigt in schematischer Form den Einsatz eines akusto-optischen Modulators an Stelle eines diffraktiven optischen Elements 2 für die Teilung eines Laserstrahls in Teilstrahlen 1.1 und 1.2.

## Patentansprüche

1. Verfahren zur Ausbildung einer Oberflächenstrukturierung an Oberflächen von Bauteilen mit einem Laserstrahl, bei der der Laserstrahl (1) auf ein diffraktives optisches Element (2) oder einen akusto-optischen Modulator gerichtet und mit dem diffraktiven optischen Element (2) oder dem akusto-optischen Modulator in mindestens zwei Teilstrahlen (1.1 und 1.2) aufgespalten wird und die Teilstrahlen (1.1 und 1.2) mit einem Winkel α in Bezug zur optischen Achse des Laserstrahls (1) auf mindestens ein weiteres optisches Element (3), das für die Laserstrahlung transparent ist, gerichtet werden; wobei
die Teilstrahlen (1.1 und 1.2) mit einer zwischen dem/den weiteren optischen Element(en) (3) und einer zu bearbeitenden Bauteiloberfläche angeordneten fokussierenden optische Linse (4) so fokussiert werden, dass sie an einer gemeinsamen Position mit einem Einfallswinkel β in Bezug zur optischen Achse des Laserstrahls (1) auf die Oberfläche des Bauteils auftreffen; **dadurch gekennzeichnet, dass**
das/die weitere(n) optische(n) Element(e) (3) eine erste Oberfläche aufweist/aufweisen und eine zweite Oberfläche aufweist/aufweisen, die in einem Winkel zur optischen Achse des Laserstrahls (1) geneigt ist, an der die Teilstrahlen (1.1 und 1.2) durch optische Brechung in ihrer Strahlrichtung verändert werden, und
der Abstand d1 zwischen dem diffraktiven optischen Element (2) oder dem akusto-optischen Modulator und dem weiteren optischen Element (3) verändert wird, um die Interferenzperiode zu verändern.

2. Verfahren nach Anspruch 1, **dadurch gekennzeichnet, dass** die Teilstrahlen (1.1, 1.2) mit dem gleichen Winkel α in Bezug zur optischen Achse des Laserstrahls auf mindestens ein weiteres optisches Element gerichtet werden und/oder
die Teilstrahlen (1.1, 1.2) mit dem gleichen Einfallswinkel β in Bezug zur optischen Achse des Laserstrahls (1) auf die Oberfläche des Bauteils gerichtet werden.

3. Verfahren nach einem der vorhergehenden Ansprüche, **dadurch gekennzeichnet, dass** als mindestens ein weiteres optisches Element (3) ein optisches Prisma, eine Keilplatte, ein an einer Oberfläche in Form einer Pyramide oder eines Pyramidenstumpfes, in Form eines Polyeders, in Form eines Kegels oder eines Kegelstumpfes ausgebildetes optisches Element (3) eingesetzt und als diffraktives optisches Element (2) ein optisches Gitter eingesetzt wird.

4. Verfahren nach einem der vorhergehenden Ansprüche, **dadurch gekennzeichnet, dass** das diffraktive optische Element um eine Achse gedreht wird.

5. Verfahren nach einem der vorhergehenden Ansprüche, **dadurch gekennzeichnet, dass** ein- oder zweidimensionale Interferenzmuster, deren Periode und/oder Ausrichtung veränderbar ist, ausgebildet werden.

6. Verfahren nach einem der vorhergehenden Ansprüche, **dadurch gekennzeichnet, dass** der Laserstrahl (1) mit mindestens einem reflektierenden Element (5) mindestens eindimensional ausgelenkt auf das diffrakive optische Element (2) oder den akusto-optischen Modulator gerichtet wird.

7. Verfahren nach einem der vorhergehenden Ansprüche, **dadurch gekennzeichnet, dass** das diffraktive optische Element (2) um eine parallel zur optischen Achse eines senkrecht auf das diffraktive optische Element (2) gerichteten Laserstrahls (1) gedreht wird.

8. Verfahren nach einem der vorhergehenden Ansprüche, **dadurch gekennzeichnet, dass** der Abstand d2 zwischen dem weiteren optischen Element (3) und der fokussierenden optischen Linse (4) verändert wird.

9. Verfahren nach einem der vorhergehenden Ansprüche, **dadurch gekennzeichnet, dass** mit einem zusätzlichen optischen Element (7) das Intensitätsprofil des Laserstrahls (1) modifiziert und dabei insbesondere ein nichtrotationssymmetrisches oder über die Querschnittsfläche inhomogenes Intensitätsprofil des Laserstrahls (1) erreicht wird.

10. Anordnung zur Durchführung des Verfahrens nach einem der vorhergehenden Ansprüche, **dadurch gekennzeichnet, dass** ein Laserstrahl (1) zur Aufteilung in Teilstrahlen (1.1, 1.2) auf ein diffraktives optisches Element (2) oder einen akusto-optischen Modulator gerichtet ist und die Teilstrahlen (1.1, 1.2) mit einem Winkel α in Bezug zur optischen Achse des Laserstrahls (1) auf mindestens ein weiteres optisches Element (3), das für die Laserstrahlung transparent ist, gerichtet sind und die Teilstrahlen (1.1 und 1.2) mittels einer zwischen dem/den weiteren optischen Element(en) (3) und einer zu bearbeitenden Bauteiloberfläche angeordneten fokussierenden optische Linse (4) an einer gemeinsamen Position mit einem Einfallswinkel β in Bezug zur optischen Achse des Laserstrahls (1) auf die Oberfläche des Bauteils auftreffen; **dadurch gekennzeichnet, dass** der Abstand d1 zwischen dem diffraktiven optischen Element (2) oder dem akusto-optischen Modulator und dem weiteren optischen Element (3) veränderbar ist; wobei
das/die weitere(n) optische(n) Element(e) (3) eine erste Oberfläche aufweist/aufweisen und eine zweite Oberfläche aufweist/aufweisen, die in einem Winkel zur optischen Achse des Laserstrahls (1) geneigt ist, an der die Teilstrahlen (1.1 und 1.2) durch optische Brechung in ihrer Strahlrichtung verändert werden.

11. Anordnung nach Anspruch 10, **dadurch gekennzeichnet, dass** ein weiteres optisches Element (3) ein optisches Prisma, eine Keilplatte, ein an einer Oberfläche in Form einer Pyramide oder eines Pyramidenstumpfes, in Form eines Polyeders, in Form eines Kegels oder eines Kegelstumpfes ausgebildetes optisches Element (3) und das diffraktive optische Element (2) ein optisches Gitter ist.

12. Anordnung nach Anspruch 10 oder 11, **dadurch gekennzeichnet, dass** das diffraktive optische Element (2) um eine Achse drehbar ist.

13. Anordnung nach einem der Ansprüche 13 bis 15, **dadurch gekennzeichnet, dass** im Strahlengang des Laserstrahls (1) oder der Teilstrahlen (1.1, 1.2) mindestens ein um mindestens eine Achse verschwenkbares reflektierendes Element (5) angeordnet ist.

14. Anordnung nach einem der Ansprüche 10 bis 13, **dadurch gekennzeichnet, dass** ein strahlformendes reflektives oder transmissives Element (7), das über seine Fläche einen Reflexions- oder Transmissionsgradienten aufweist, oder ein adaptiv optisches Element im Strahlengang des Laserstrahls (1) vor dem diffraktiven optischen Element (2) oder dem akusto-optischen Modulator angeordnet ist.

15. Anordnung nach einem der Ansprüche 10 bis 14, **dadurch gekennzeichnet, dass** ein adaptives optisches Element (7) eine unregelmäßig gekrümmte Oberfläche aufweist oder dessen Oberfläche, auf die der Laserstrahl gerichtet wird, in ihrer Wölbung veränderbar ist.

## Claims

1. A method for forming a surface structuring at surfaces of components using a laser beam, wherein the laser beam (1) is directed onto a diffractive optical element (2) or onto an acousto-optic modulator and is split by the diffractive optical element (2) or by the acousto-optic modulator into at least two part beams (1.1 and 1.2); and
the part beams (1.1 and 1.2) are directed onto at least one further optical element (3), which is transparent for the laser radiation, at an angle α with respect to the optical axis of the laser beam (1), wherein the part beams (1.1 and 1.2) are focused by a focusing optical lens (4) arranged between the further optical element(s) 3 and a component surface to be processed such that they are incident at a common position on the surface of the component at an angle of incidence β with respect to the optical axis of the laser beam (1); **characterized in that** the further optical element(s) (3) has/have a first surface and a second surface which is inclined at an angle to the optical axis of the laser beam (1) at which the beam direction of the part beams (1.1 and 1.2) is changed by optical refraction; and
the distance d1 between the diffractive optical element (2) or the acousto-optic modulator and the further optical element (3) is changed to change the interference period.

2. A method in accordance with claim 1, **characterized in that** the part beams (1.1, 1.2) are directed onto at least one further optical element at the same angle α with respect to the optical axis of the laser beam; and/or
the part beams (1.1, 1.2) are directed onto the surface of the component at the same angle of incidence β with respect to the optical axis of the laser beam (1).

3. A method in accordance with one of the preceding claims, **characterized in that** an optical prism, a wedge plate or an optical element (3) formed at a surface in the form of a pyramid or of a truncated pyramid, in the form of a polyhedron, in the form of a cone or of a truncated cone is used as the at least one further optical element (3) and an optical grating is used as the diffractive optical element (2).

4. A method in accordance with one of the preceding claims, **characterized in that** the diffractive optical element is rotated about an axis.

5. A method in accordance with one of the preceding claims, **characterized in that** one-dimensional or two-dimensional interference patterns are formed whose period and/or alignment is/are changeable.

6. A method in accordance with one of the preceding claims, **characterized in that** the laser beam (1) is directed, deflected by at least one reflective element (5), at least one-dimensionally onto the diffractive optical element (2) or onto the acousto-optic modulator.

7. A method in accordance with one of the preceding claims, **characterized in that** the diffractive optical element (2) is rotated about an axis in parallel with the optical axis of the laser beam (1) directed in a perpendicular manner onto the diffractive optical element (2).

8. A method in accordance with one of the preceding claims, **characterized in that** the distance d2 between the further optical element (3) and the focusing optical lens (4) is changed.

9. A method in accordance with one of the preceding claims, **characterized in that** the intensity profile of the laser beam (1) is modified by an additional optical element (7) and thereby a non-rotationally symmetrical intensity profile of the laser beam (1) or an intensity profile of the laser beam (1) inhomogeneous over the cross-sectional surface is achieved in particular.

10. An arrangement for carrying out the method in accordance with one of the preceding claims, **characterized in that** a laser beam (1) is directed onto a diffractive optical element (2) or onto an acousto-optic modulator for splitting into part beams (1.1, 1.2) and the part beams (1.1, 1.2) are directed onto at least one further optical element (3) which is transparent for the laser radiation at an angle α with respect to the optical axis of the laser beam (1), and
the part beams (1.1 and 1.2) are incident at a common position at an angle of incidence β with respect to the optical axis of the laser beam (1) onto the surface of the component by means of a focusing optical lens (4) arranged between the further optical element(s) (3) and a component surface to be processed, **characterized in that** the distance d1 between the diffractive optical element (2) or the acousto-optic modulator and the further optical element (3) is changeable, wherein
the further optical element(s) (3) has/have a first surface and a second surface which is inclined at an angle to the optical axis of the laser beam (1) at which the beam direction of the part beams (1.1 and 1.2) is changed by optical refraction.

11. An arrangement in accordance with claim 10, **characterized in that** a further optical element (3) is an optical prism, a wedge plate, an optical element (3) formed at a surface in the form of a pyramid or of a truncated pyramid, in the form of a polyhedron, in the form of a cone or of a truncated cone and the diffractive optical element (2) is an optical grating.

12. An arrangement in accordance with claim 10 or claim 11, **characterized in that** the diffractive optical element (2) is rotatable about an axis.

13. An arrangement in accordance with one of the claims 13 to 15, **characterized in that** at least one reflective element (5), which is pivotable about at least one axis, is arranged in the optical path of the laser beam (1) or of the part beams (1.1, 1.2).

14. An arrangement in accordance with one of the claims 10 to 13, **characterized in that** a beam-shaping reflective or transmitting element (7), which has a reflection gradient or a transmission gradient over its surface, or an adaptive optical element is/are arranged in front of the diffractive optical element (2) or the acousto-optic modulator in the optical path of the laser beam (1).

15. An arrangement in accordance with one of the claims 10 to 14, **characterized in that** an adaptive optical element (7) has an irregularly curved surface or its surface onto which the laser beam is directed is changeable with respect to its curvature.

## Revendications

1. Procédé de réalisation d'une structure de surface sur des surfaces de composants avec un rayon laser, dans lequel le rayon laser (1) est dirigé vers un élément optique à diffraction (2) ou un modulateur acousto-optique et est divisé avec l'élément optique à diffraction (2) ou le modulateur acousto-optique en au moins deux rayons partiels (1.1 et 1.2) et les rayons partiels (1.1 et 1.2) sont dirigés avec un angle α par rapport à l'axe optique du rayon laser (1) vers au moins un autre élément optique (3) qui est transparent pour le rayon laser,
les rayons partiels (1.1 et 1.2) étant focalisés avec une lentille optique de focalisation (4) disposée entre le ou les autres éléments optiques (3) et une surface de composant à traiter de façon à ce qu'ils arrivent à une position commune avec un angle d'incidence β par rapport à l'axe optique du rayon laser (1) sur la surface du composant ;
**caractérisé en ce que**
le ou les autres éléments optiques (3) comprennent une première surface et une deuxième surface, qui sont inclinées avec un angle par rapport à l'axe optique du rayon laser (1), au niveau desquelles la direction des rayons partiels (1.1 et 1.2) est modifiée par réfraction optique et
la distance d1 entre l'élément optique à diffraction (2) ou le modulateur acousto-optique et l'autre élément optique (3) est modifiée afin de modifier la période d'interférence.

2. Procédé selon la revendication 1, **caractérisé en ce que** les rayons partiels (1.1, 1.2) sont dirigés avec le même angle α par rapport à l'axe optique du rayon laser vers au moins un autre élément optique et/ou les rayons partiels (1.1, 1.2) sont dirigés avec le même angle d'incidence β par rapport à l'axe optique du rayon laser (1) vers la surface du composant.

3. Procédé selon l'une des revendications précédentes, **caractérisé en ce que**, en tant qu'au moins un autre élément optique (3), un prisme optique, une plaque cunéiforme, un élément optique (3) présentant, au niveau d'une surface, la forme d'une pyramide ou d'un tronc de pyramide, la forme d'un polyèdre, la forme d'un cône ou d'un tronc de cône est utilisé et une grille optique est utilisée en tant qu'élément optique à diffraction (2).

4. Procédé selon l'une des revendications précédentes, **caractérisé en ce que** l'élément optique à diffraction est tourné autour d'un axe.

5. Procédé selon l'une des revendications précédentes, **caractérisé en ce qu'**un motif d'interférence mono- ou bidimensionnel, dont la période et/ou l'orientation est variable, est réalisé.

6. Procédé selon l'une des revendications précédentes, **caractérisé en ce que** le rayon laser (1) est dévié de manière monodimensionnelle avec au moins un élément réfléchissant (5) vers l'élément optique à diffraction (2) ou le modulateur acousto-optique.

7. Procédé selon l'une des revendications précédentes, **caractérisé en ce que** l'élément optique à diffraction (2) est tourné parallèlement autour de l'axe optique d'un rayon laser (1) dirigé perpendiculairement vers l'élément optique à diffraction (2).

8. Procédé selon l'une des revendications précédentes, **caractérisé en ce que** la distance d2 entre l'autre élément optique (3) et la lentille optique de focalisation (4) est modifiée.

9. Procédé selon l'une des revendications précédentes, **caractérisé en ce que**, avec un élément optique supplémentaire (7), le profil d'intensité du rayon laser (1) est modifié et plus particulièrement un profil d'intensité sans symétrie de rotation ou inhomogène sur la surface de section du rayon laser (1) est obtenu.

10. Dispositif pour la réalisation du procédé selon l'une des revendications précédentes, **caractérisé en ce qu'**un rayon laser (1)est dirigé, pour sa division en rayons partiels (1.1, 1.2), vers un élément optique à diffraction (2) ou un modulateur acousto-optique et les rayons partiels (1.1, 1.2) sont dirigés, avec un angle α par rapport à l'axe optique du rayon laser (1), vers au moins un autre élément optique (3), qui est transparent pour le rayon laser, et
les rayons partiels (1.1 et 1.2) sont focalisés avec une lentille optique de focalisation (4) disposée entre le ou les autres éléments optiques (3) et une surface de composant à traiter de façon à ce qu'ils arrivent à une position commune avec un angle d'incidence β par rapport à l'axe optique du rayon laser (1) sur la surface du composant ;
**caractérisé en ce que**
la distance d1 entre l'élément optique à diffraction (2) ou le modulateur acousto-optique et l'autre élément optique (3) est variable ;
le ou les autres éléments optiques (3) comprenant une première surface et une deuxième surface, qui sont inclinées avec un angle par rapport à l'axe optique du rayon laser (1), au niveau desquelles la direction des rayons partiels (1.1 et 1.2) est modifiée par réfraction optique.

11. Dispositif selon la revendication 10, **caractérisé en ce qu'**un autre élément optique (3) est un prisme optique, une plaque cunéiforme, un élément optique (3) présentant, au niveau d'une surface, la forme d'une pyramide ou d'un tronc de pyramide, la forme d'un polyèdre, la forme d'un cône ou d'un tronc de cône est utilisé et l'élément optique à diffraction (2) est une grille optique.

12. Dispositif selon la revendication 10 ou 11, **caractérisé en ce que** l'élément optique à diffraction (2) est rotatif autour d'un axe.

13. Dispositif selon l'une des revendications 13 à 15, **caractérisé en ce que**, dans le trajet du rayon laser (1) ou des rayons partiels (1.1, 1.2), est disposé au moins un élément réfléchissant (5) pivotant autour d'un axe.

14. Dispositif selon l'une des revendications 10 à 13, **caractérisé en ce qu'**un élément réfléchissant ou transmissif (7) formant les rayons, qui présente sur sa surface un gradient de réflexion ou de transmission, ou un élément optique adaptatif est disposé dans le trajet du rayon laser (1) avant l'élément optique à diffraction (2) ou le modulateur acousto-optique.

15. Dispositif selon l'une des revendications 10 à 14, **caractérisé en ce qu'**un élément optique adaptatif (7) présente une surface à courbure irrégulière ou dont la courbure de la surface, vers laquelle est dirigé le rayon laser, est variable.
